# EUROPEAN PATENT APPLICATION

(11) **EP 2 445 014 A1**
(43) Date of publication of application: **25.04.2012**
(21) Application number: 09846191.6
(22) Date of filing: 18.06.2009
(51) Int. Cl.: H01L 31/04

(54) **SOLAR CELL MANUFACTURING METHOD AND SOLAR CELL MANUFACTURING DEVICE**

(71) Applicant: ULVAC, INC., Chigasaki-shi Kanagawa 253-8543 (JP)
(72) Inventor: YAMAMURO Kazuhiro, Chigasaki-shi Kanagawa 253-8543 (JP); SATO Seiichi, Chigasaki-shi Kanagawa 253-8543 (JP); YAHAGI Mitsuru, Chigasaki-shi Kanagawa 253-8543 (JP); YUYAMA Junpei, Chigasaki-shi Kanagawa 253-8543 (JP); NAKAMURA Kyuzo, Chigasaki-shi Kanagawa 253-8543 (JP)
(74) Representative: Fehn, Christoph
(86) International application number: PCT/JP2009/061135
(87) International publication number: WO 2010/146698

(57) **Abstract**

A photovoltaic cell manufacturing method includes: forming a photoelectric converter (12) including a plurality of compartment elements (21, 21s), the compartment elements (21, 21 s) adjacent to each other being electrically connected; determining the compartment element (21s) having a structural defect (R, A1, A2, A3) in the photoelectric converter (12); narrowing down a region (Z) in which the structural defect exists in the compartment element (21 s) based on a resistance distribution which is obtained by measuring resistances of a plurality of portions between the compartment elements (21, 21s) adjacent to each other, image-capturing the inside of the narrowed region (Z) in which the structural defect exists by use of an image capturing section (24), accurately determining a position of the structural defect from the obtained image so that a portion in which the structural defect exists in the compartment element (21s) is restricted; and removing the structural defect by irradiating the portion in which the structural defect exists with a laser beam.

## Description

### BACKGROUND OF THE INVENTION

### Field of the Invention

The present invention relates to a photovoltaic cell manufacturing method and a photovoltaic cell manufacturing apparatus, and specifically relates to a photovoltaic cell manufacturing method and a photovoltaic cell manufacturing apparatus in which it is possible to detect a structural defect at a low cost and repair the structural defect.

### Background Art

In recent years, in view of efficient use of energy, photovoltaic cells have been more widely used than ever before.

Specifically, a photovoltaic cell in which a silicon single crystal is utilized has a high level of energy conversion efficiency per unit area.

However, in the photovoltaic cell in which the silicon single crystal is utilized, a silicon single crystal ingot is sliced, and a sliced silicon wafer is used in the photovoltaic cell; therefore, a large amount of energy is spent for manufacturing the ingot, and the manufacturing cost is high.

Specifically, at the moment, in a case of realizing a photovoltaic cell having a large area which is placed outdoors, when the photovoltaic cell is manufactured by use of a silicon single crystal, the cost considerably increases.

Therefore, a low-cost photovoltaic cell which can be further inexpensively manufactured than ever before and employ a thin film made of amorphous silicon is in widespread use.

An amorphous silicon photovoltaic cell uses semiconductor films of a layered structure that is referred to as a pin-junction in which an amorphous silicon film (i-type) is sandwiched between p-type and n-type silicon films, the amorphous silicon film (i-type) generating electrons and holes when receiving light.

An electrode is formed on both faces of the semiconductor films.

The electrons and holes generated by sunlight actively transfer due to a difference in the electrical potentials between p-type and n-type semiconductors, and a difference in the electrical potentials between both faces of the electrodes is generated when the transfer thereof is continuously repeated.

As a specific structure of the amorphous silicon photovoltaic cell as described above, for example, a structure is employed in which a transparent electrode is formed as a lower electrode by forming TCO (Transparent Conductive Oxide) or the like on a glass substrate, and a semiconductor film composed of amorphous silicon and an upper electrode that becomes an Ag thin film or the like are formed thereon.

In the amorphous silicon photovoltaic cell that is provided with a photoelectric converter constituted of the foregoing upper and lower electrodes and the semiconductor film, the difference in the electrical potentials is small if each of the layers having a large area is only uniformly formed on the substrate, and there is a problem in that the resistance increases.

Consequently, the amorphous silicon photovoltaic cell is formed by, for example, forming compartment elements so as to electrically separate the photoelectric converter into the compartment elements by a predetermined size, and by electrically connecting adjacent compartment elements with each other.

Specifically, a structure is adopted in which a groove that is referred to as a scribing line is formed on the photoelectric converter having a large area uniformly formed on the substrate by use of laser light or the like, a plurality of compartment elements formed in a rectangular shape is obtained, and the compartment elements are electrically connected in series.

However, in the amorphous silicon photovoltaic cell having the foregoing structure, it is known that several structural defects occur during a manufacturing step therefor.

For example, in forming the amorphous silicon film, the upper electrode and the lower electrode may be locally short-circuited because particles mix thereto or pin holes occur therein.

In addition, when the photoelectric converter that was formed on the substrate is divided into a plurality of compartment elements by the scribing line, a metal film that forms the upper electrode is molten and reaches the lower electrode along the scribing line, and the upper electrode and the lower electrode may be locally short-circuited.

In the photoelectric converter as mentioned above, when structural defects occur such that the upper electrode and the lower electrode are locally short-circuited with the semiconductor film interposed therebetween, the defects cause a malfunction such that power generation voltage or photoelectric conversion efficiency are degraded.

Consequently, in the process for manufacturing a conventional amorphous silicon photovoltaic cell, by detecting the structural defects such as the foregoing short-circuiting or the like and by removing the portions at which the structural defects occur, malfunction is prevented.

For example, Japanese Unexamined Patent Application, First Publication No. H09-266322 and Japanese Unexamined Patent Application, First Publication No. 2002-203978 disclose a method for determining the compartment element in which the structural defects exist, by entirely applying a bias voltage to each compartment element that was separated by the scribing line and by detecting Joule heat being generated at short-circuiting portions by use of an infrared light sensor.

In addition, a method for enlarging and observing the top face of all compartment elements by use of a CCD camera or the like, or a method for irradiating a compartment element with light, measuring and comparing the FF (fill factor) of each thereof, and thereby determining a compartment element in which structural defects exist has been also known.

However, in the method for detecting the defects by applying the bias voltage to entire compartment element as described above, it is possible to determine a rough position of the defect in the compartment element; but, it is difficult to determine the exact position thereof, it is necessary to scan the compartment element with an infrared light sensor, and there is thereby a problem in that the cost of the apparatus increases due to detecting the defect and the detection precision.

In addition, since the bias voltage is applied with a degree such that a defect portion becomes heated, there is a concern that the semiconductor film will be damaged.

In the method for detecting defects by enlarging and observing images by use of a CCD camera or the like, it is necessary to scan the entire photovoltaic cell using the camera, specifically, in the case where the photovoltaic cell has a large area, there is a problem in that the detection of structural defects is complex and time therefor is required.

In addition, there is a concern that defects which do not appear on a top layer are not detected.

In the method for irradiating a compartment element with light and measuring the FF of each thereof, it is possible to detect a compartment element in which the defects exist, it is difficult to determine as to where the defects exist in the compartment element.

Consequently, in the above-described method for detecting the defects, since only a rough position of the defect is determined, a semiconductor film is removed in a wide region thereof when repairing the defect portions using a laser light or the like; there are problems not only of the photovoltaic cell having undesirable characteristics but also causing disfigurement of the photovoltaic cell.

In addition, in the case where a rough position of the defect is only determined and the defects are removed by applying the bias voltage, it is necessary to increase the bias voltage.

However, when a higher degree of the bias voltage than necessary is applied, there is a problem in that nondefective portions in which defects do not occur are damaged.

### SUMMARY OF THE INVENTION

The invention was made with respect to the above-described problems, and has an object to provide a method and an apparatus for manufacturing a photovoltaic cell, where portions in which a structural defect is generated are accurately determined in a short amount of time without significantly damaging a photoelectric converter of a photovoltaic cell, and it is possible to reliably remove and repair the determined structural defect.

In order to solve the above-described problems, the invention provides the following photovoltaic cell manufacturing method.

In particular, a photovoltaic cell manufacturing method of a first aspect of the invention includes: forming a photoelectric converter including a plurality of compartment elements, the compartment elements adjacent to each other being electrically connected; determining the compartment element having a structural defect in the photoelectric converter (defect compartment determining step); narrowing down a region in which the structural defect exists in the compartment element based on a resistance distribution which is obtained by measuring resistances of a plurality of portions between the compartment elements adjacent to each other, image-capturing the inside of the narrowed region in which the structural defect exists by use of an image capturing section, accurately determining a position of the structural defect from the obtained image so that a portion in which the structural defect exists in the compartment element is restricted (defect portion determining step); and removing the structural defect by irradiating the portion in which the structural defect exists with a laser beam (repairing step).

In the photovoltaic cell manufacturing method of the first aspect of the invention, it is preferable that, when the portion in which the structural defect exists is restricted (defect portion determining step), a degree of density for measuring be changed at least two times or more and the resistances be measured.

Additionally, it is preferable that a resistance measuring apparatus having four probes be used to measure the resistances.

Furthermore, the invention provides the following a photovoltaic cell manufacturing apparatus.

In particular, a photovoltaic cell manufacturing apparatus of a second aspect of the invention manufactures a photovoltaic cell including a photoelectric converter having a plurality of compartment elements. The apparatus includes: a resistance measuring section that measures resistances of a plurality of portions between the compartment elements adjacent to each other in order to narrow down a region in which a structural defect exists in the compartment element having the structural defect in the photoelectric converter; an image capturing section that image-captures the inside of the narrowed region in which the structural defect exists and accurately determines a position of the structural defect; and a repairing section that removes the structural defect by irradiating the structural defect with a laser beam.

### Effects of the Invention

According to the photovoltaic cell manufacturing method of the first aspect of the invention, firstly, a photovoltaic cell including a compartment element having a structural defect is sorted out in the defect compartment determining step.

Consequently, the sorted photovoltaic cell having the defect is only transferred to the defect portion determining step.

In the defect portion determining step, the portion in which a defect exists is determined with precision.

Because of this, it is possible to effectively manufacture a photovoltaic cell without the structural defect.

Furthermore, in the defect portion determining step, the resistance distribution between the compartment elements adjacent to each other is measured and the region in which the structural defect exists is determined in the longitudinal direction of the compartment element.

Thereafter, furthermore, by image-capturing the narrowed region using the image capturing section, it is possible to accurately determine the pinpoint position at which the structural defect exists in the compartment element.

In the case of image-capturing an object to be inspected and having a large area using a conventional defect determining method, a time-consuming operation is necessary.

In contrast, in the defect determining method of the invention, the time-consuming image-capturing method applied when an object to be inspected has a large area is only used for image-capturing the region having a small area which is narrowed down in advance based on the resistance distribution. The resistance distribution can be measured in a short amount of time.

For this reason, it is possible to promptly and accurately determine the position of the structural defect in an extremely short amount of time.

As a result, it is possible to remove the minimized region including a defect in the repairing step, and it is possible to repair the defect portions without significantly degrading the characteristics of the photovoltaic cell and without causing disfigurement thereof.

Additionally, according to the photovoltaic cell manufacturing apparatus of the second aspect of the invention, since the resistance measuring section measuring the resistances of a plurality of portions between the compartment elements and the image capturing section image-capturing the region having a small area which is narrowed by use of the resistance measuring section are provided in order to determine the position of the structural defect, it is possible to determine the position in which the defect exists in the compartment element in a short amount of time with precision.

Furthermore, it is possible to remove the minimized region including a defect in the repairing step, and it is possible to repair the defect portions without significantly degrading the characteristics of the photovoltaic cell and without causing disfigurement thereof.

### BRIEF DESCRIPTION OF THE DRAWINGS

FIG. 1 is an enlarged perspective view showing an example of a main section of an amorphous silicon type photovoltaic cell.
FIG. 2 is a cross-sectional view showing an example of the amorphous silicon type photovoltaic cell.
FIG. 3 is a flowchart illustrating a photovoltaic cell manufacturing method of the invention.
FIG. 4 is a cross-sectional view showing an example of a structural defect and the condition of the structural defect after being repaired.
FIG. 5 is an explanatory diagram showing a condition of a defect compartment determining step.
FIG. 6 is a view showing an example of measuring the resistance in the defect compartment determining step.
FIG. 7 is an explanatory diagram showing a condition of a defect portion determining step.
FIG. 8 is a view showing an example of measuring the resistance in the defect portion determining step.
FIG. 9 is an explanatory diagram illustrating an example of a defect portion determining step and a repairing step.
FIG. 10 is an explanatory diagram illustrating an example of a defect portion determining step.

### DESCRIPTION OF THE PREFERRED EMBODIMENTS

Hereinafter, a photovoltaic cell manufacturing method related to the invention, and a photovoltaic cell manufacturing apparatus of the invention used in the method will be described with reference to drawings.

The embodiment is specifically explained for appropriately understanding the scope of the invention, and does not limit the invention unless otherwise determined.

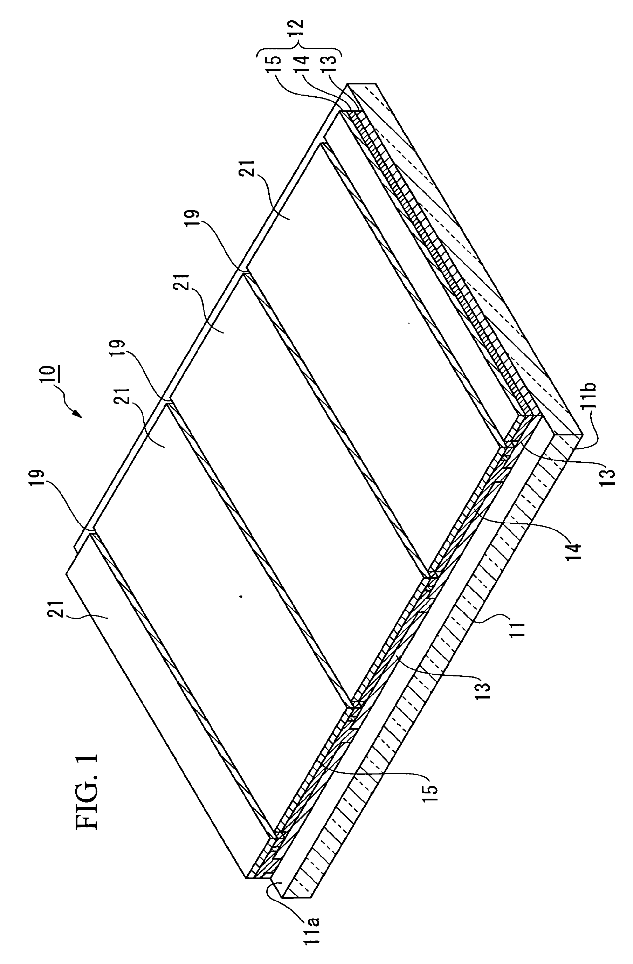

FIG. 1 is an enlarged perspective view showing an example of a main section of an amorphous silicon type photovoltaic cell which is manufactured by a photovoltaic cell manufacturing method of the invention.

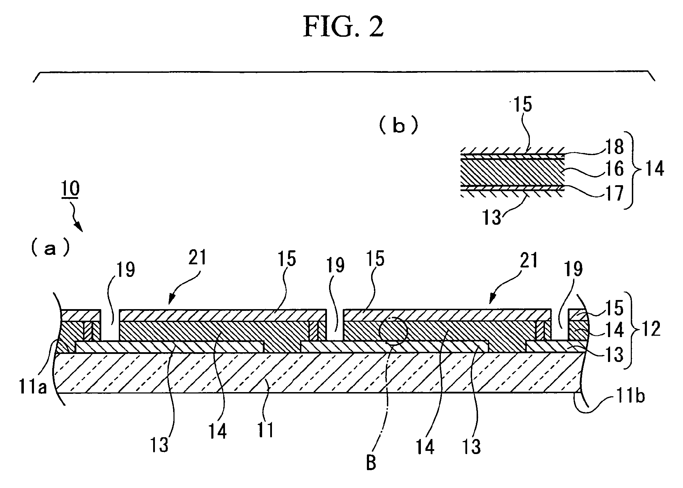

In addition, FIG. 2(a) is a cross-sectional view showing a layered structure of the photovoltaic cell shown in FIG. 1.

FIG. 2 (b) is an enlarged cross-sectional view showing an enlarged portion indicated by reference numeral B in FIG. 2(a).

A photovoltaic cell 10 has a photoelectric converter 12 formed on a first face 11a (one of faces) of a transparent substrate 11 having an insulation property.

It is only necessary for the substrate 11 to be formed of an insulation material having a high level of sunlight transparency and durability such as a glass or a transparent resin.

Sunlight is incident on a second face 11b (the other of faces) of the substrate 11.

In the photoelectric converter 12, a first electrode layer 13 (lower electrode), a semiconductor layer 14, and a second electrode layer 15 (upper electrode) are stacked in layers in this order from the substrate 11.

It is only necessary for the first electrode layer 13 (lower electrode) to be formed of a transparent conductive material, for example, an oxide of metal having an optical transparency such as TCO or ITO (Indium Tin Oxide).

In addition, it is only necessary for the second electrode layer 15 (upper electrode) to be formed of a conductive metal film such as Ag or Cu.

As shown in FIG. 2 (b), the semiconductor layer 14 has, for example, a pin-junction structure in which an i-type amorphous silicon film 16 is formed and sandwiched between a p-type amorphous silicon film 17 and an n-type amorphous silicon film 18.

Consequently, when sunlight is incident to the semiconductor layer 14, electrons and holes are generated, electrons and holes actively transfer due to a difference in the electrical potentials between the p-type amorphous silicon film 17 and the n-type amorphous silicon film 18; and a difference in the electrical potentials between the first electrode layer 13 and the second electrode layer 15 is generated when the transfer thereof is continuously repeated (photoelectric conversion).

The photoelectric converter 12 is divided by scribing lines 19 (scribing lines) into a plurality of compartment elements 21 whose external form is rectangular shape.

The compartment elements 21 are electrically separated from each other, and adjacent compartment elements 21 are electrically connected in series therebetween.

In this structure, the photoelectric converter 12 has a structure in which all of the compartment elements 21 are electrically connected in series.

In the structure, it is possible to extract an electrical current with a high degree of difference in the electrical potentials.

The scribing lines 19 are formed, for example, by forming grooves with a predetermined distance therebetween on the photoelectric converter 12 using a laser beam or the like after the photoelectric converter 12 has been uniformly formed on the first face 11a of the substrate 11.

In addition, it is preferable that a protective layer (not shown) made of a resin of insulation or the like be further formed on the second electrode layer 15 (upper electrode) constituting the foregoing photoelectric converter 12.

A manufacturing method for manufacturing a photovoltaic cell having the foregoing structure will be described.

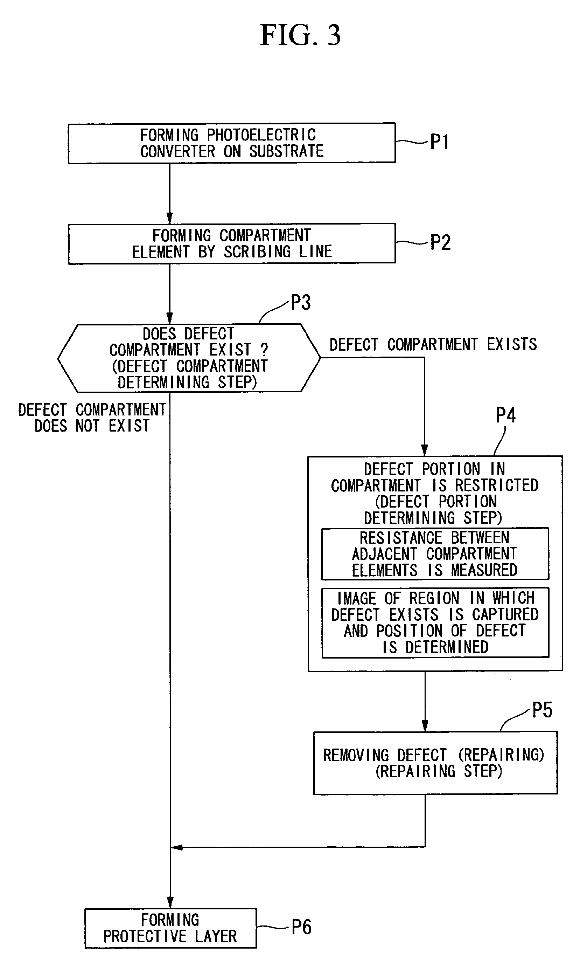

FIG. 3 is a flowchart illustrating a photovoltaic cell manufacturing method of a first embodiment of the invention in a stepwise manner.

In the method, specifically, steps between a step of detecting a structural defect and a step of repairing will be described in detail.

Firstly, as shown in FIG. 1, a photoelectric converter 12 is formed on a first face 11a of a transparent substrate 11 (photoelectric converter formation step: P1).

It is only necessary for the structure of the photoelectric converter 12 to be, for example, a structure in which a first electrode layer 13 (lower electrode), a semiconductor layer 14, and a second electrode layer 15 (upper electrode) are stacked in layers in this order from the first face 11a of the substrate 11.

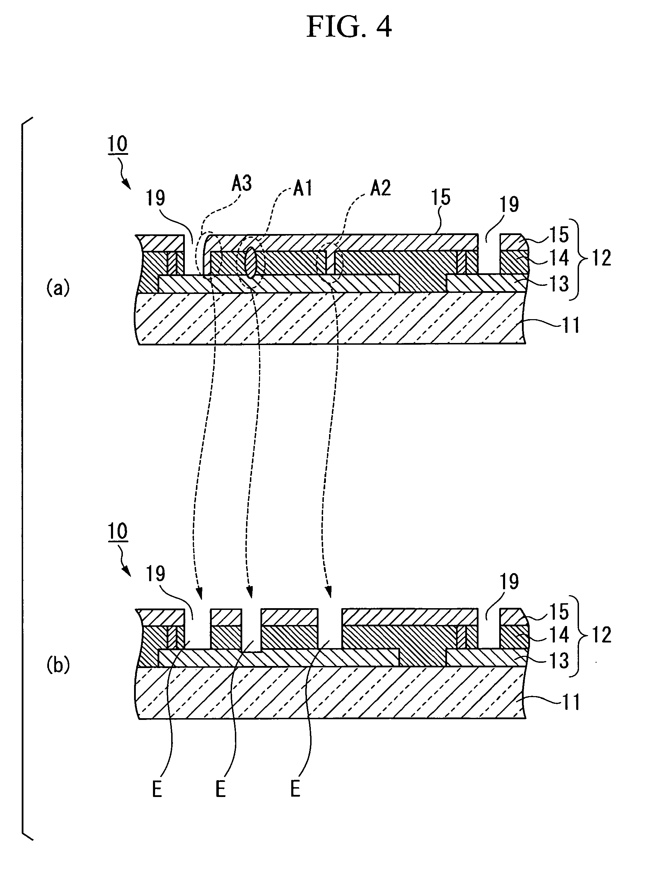

In the step of forming the foregoing photoelectric converter 12, as shown in FIG. 4 (a), there is a case where a malfunction is generated such as a structural defect A1 which is caused by mixing impurities or the like into the semiconductor layer 14 (contamination) or a structural defect A2 at which microscopic pin holes are generated in the semiconductor layer 14.

The foregoing structural defects A1 and A2 cause the first electrode layer 13 and the second electrode layer 15 to be locally short-circuited (leakage) therebetween and the power generation efficiency to be degraded.

Next, scribing lines 19 (scribe line) are formed by irradiating the photoelectric converter 12 with, for example, a laser beam or the like; the photoelectric converter 12 is divided into a plurality of compartment elements 21 which are formed in a rectangular shape (compartment element formation step: P2).

In the foregoing step of forming the scribing lines 19, there is a case where a malfunction is generated such as a structural defect A3 or the like which is caused by the metal constituting the second electrode layer 15 being molten due to a discrepancy in irradiated positions with the laser and due to the molten metal flowing downward the groove of the scribing line 19 as shown FIG. 4 (a).

The foregoing structural defect A3 causes the first electrode layer 13 and the second electrode layer 15 to be locally short-circuited (leakage) therebetween, and degrade the power generation efficiency.

In the photovoltaic cell 10 formed by the steps as describe above, the compartment elements 21, in which structural defects (e.g., the above-described A1 to A3) exist, are specified (defect compartment determining step: P3).

In the defect compartment determining step, as a specific method for determining the compartment elements 21 in which structural defects exist, for example, measuring of the resistance, measuring of the FF (fill factor), or the like are adopted.

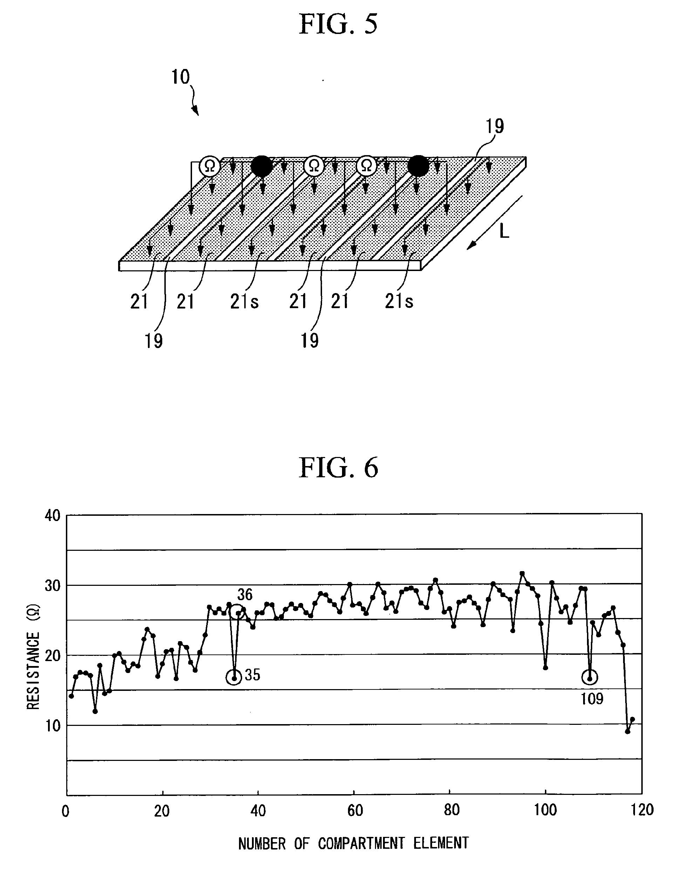

In the case where the compartment elements in which the structural defects exist 21 are determined by measuring the resistance, as shown in FIG. 5, several measuring points are set along the longitudinal direction L of the compartment element 21 formed in a rectangular shape, the resistances are measured between adjacent compartment elements 21 and 21, and it is thereby possible to determine the compartment element 21s in which the structural defects exist (defect compartment element) based on the distribution of the measured values.

FIG. 6 shows an example of the resistances measured between adjacent compartment elements in the photovoltaic cell that is constituted of, for example, 120 compartment elements.

According to the measurement result shown in FIG. 6, by comparing the resistances of compartment element 35 and compartment element 36, it is obvious that the resistance of the compartment element 35 is smaller than the resistance of the compartment element 36.

That is, it is predicted that a structural defect causing short-circuiting exists in the compartment element 35.

Similarly, the existence of a structural defect in compartment element 109 is also predicted.

In the foregoing defect compartment determining step, in the case of specifying the compartment element in which the structural defects exist by measuring the resistance, several methods are adopted as a measuring method.

For example, by use of a measuring apparatus in which a plurality of probes is arrayed along the longitudinal direction L of the compartment element 21 by a predetermined distance, a method in which the resistance between compartment elements is completed by moving the probe vertically once, or a measuring method in which the probe is scanned along the longitudinal direction L of the compartment element 21 by repeatedly moving the probe vertically at a predetermined measuring point, or the like may be used.

In the measuring of the resistance in the foregoing defect compartment determining step, any method may be used, such as a method for applying a predetermined bias voltage, a method of using a pair of probes to measure both the resistance and the electrical current value, or a method of using two pairs of probes in which one pair is used for applying a predetermined bias electrical current and the other pair is used for measuring the voltage value.

The resistance is calculated based on the voltage value and the electrical current value.

In addition, in the foregoing defect compartment determining step, not only the method for measuring the resistance but also a method may be adopted in which, for example, a photovoltaic cell is irradiated with illumination light of a predetermined light quantity, the FF (fill factor) of each compartment element is measured, and the FF values of adjacent compartment elements are compared.

In this case, a compartment element in which the FF value thereof is specifically reduced is determined as the compartment element in which the structural defects exist.

After the defect compartment determining step described above, the photovoltaic cell in which the compartment element in which the structural defects exist is found is subsequently transmitted to a defect portion determining step.

In contrast, a photovoltaic cell in which structural defects in the compartment elements are not found is determined as a non-defective product, is passed through a protective layer formation step P6 or the like without modification, and is a commercial reality.

In the above-described defect compartment determining step, if the photovoltaic cell in which the structural defects in the compartment elements are found, a step for restricting a portion in which a structural defect exists in the compartment element (defect portion determining step: P4).

In the defect portion determining step, firstly, regarding only the compartment element that is found to have a structural defect in the previous step (i.e., the defect compartment determining step), a resistance between adjacent compartment elements 21 is measured along the longitudinal direction L of the compartment element.

Here, the measuring of the resistance is performed so that a measurement interval (degree of density for measuring) at which the resistances are measured in the longitudinal direction L is smaller than the measurement interval at which the resistances were measured in the previous step (i.e., the defect compartment determining step).

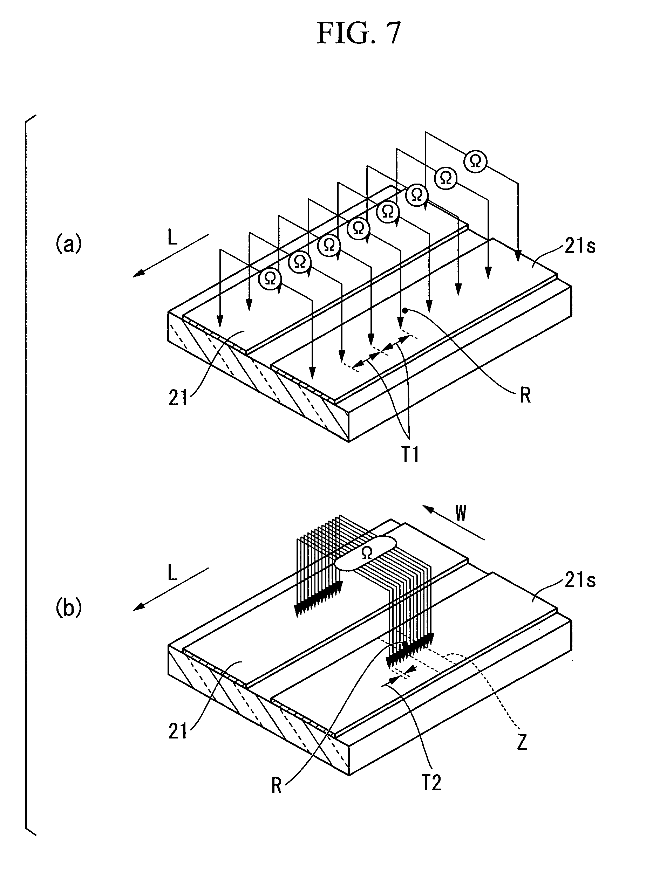

As shown in FIG. 7 (a), for example, in the entire area in the longitudinal direction L of the compartment element 21s that is found to have the structural defect R existing, the resistance is measured between adjacent compartment elements 21 by a predetermined measurement interval T1 (degree of density for measuring) at which the resistances are measured.

By measuring the resistances, a rough position of the structural defect R is determined in the longitudinal direction L of the compartment element 21 s.

It is only necessary for the measurement interval T1 at which the resistances are measured to be, for example, approximately 20 mm.

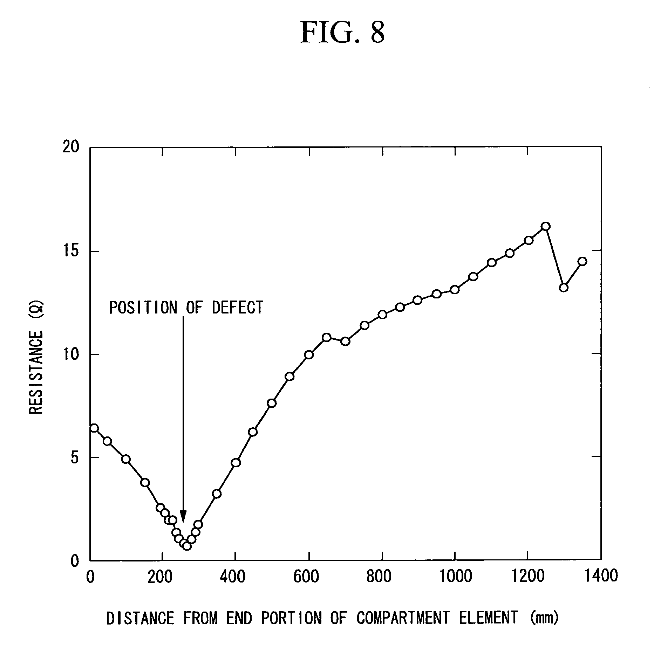

In the compartment element that is formed in a rectangular shape and that has, for example, 1400 mm of length in the longitudinal direction L (one defect exists therein), an example of measuring the resistance between adjacent compartment elements is shown in FIG. 8.

According to the measurement result shown in FIG. 8, the resistance is reduced in a direction from an end portion of the compartment terminals toward adjacent 250 mm in the distance.

In the case mentioned above where the structural defect causes the short-circuiting, the resistance is gradually lower as the position at which the defect exists is approached.

Therefore, by observing changes in resistances while measuring the resistances in the longitudinal direction L of the compartment element 21s with a predetermined interval, it is possible to know the rough position at which the structural defect R exists in the compartment element 21s.

As described above, it is preferable that, after a rough position of the structural defect R was determined in the longitudinal direction L of the compartment element 21 s, a region at which the structural defect R exists be further searched.

In particular, as described above, it is preferable that, after a rough position of the structural defect R was determined in the longitudinal direction L of the compartment element 21s, the resistances between adjacent compartment elements be measured by the measurement interval T2 that is further smaller than the above-described measurement interval T1 at an area between front and rear positions of the rough position, approximately 100 mm (refer to FIG. 7 (b)).

The measurement interval T2 is set to, for example, approximately 2 mm, and the region Z in which the structural defect R exists is narrowed down with approximately ten times the degree of accuracy of the above-described step for determining the rough position of the defect.

In the measuring of the resistance of the foregoing defect portion determining step, any method may be used, such as a method for applying a predetermined bias voltage, a method of using a pair of probes to measure both the resistance and the electrical current value, or a method of using two pairs of probes in which one pair is used for applying a predetermined bias electrical current and the other pair is used for measuring the voltage value.

A resistance is calculated based on the voltage value and the electrical current value.

In addition, in the foregoing defect portion determining step of the embodiment, the position of the defect is determined by changing the resistance measurement interval twice; however, the region Z in which the structural defect R exists in the compartment element may be more fmely narrowed down by changing the measurement interval three times or more.

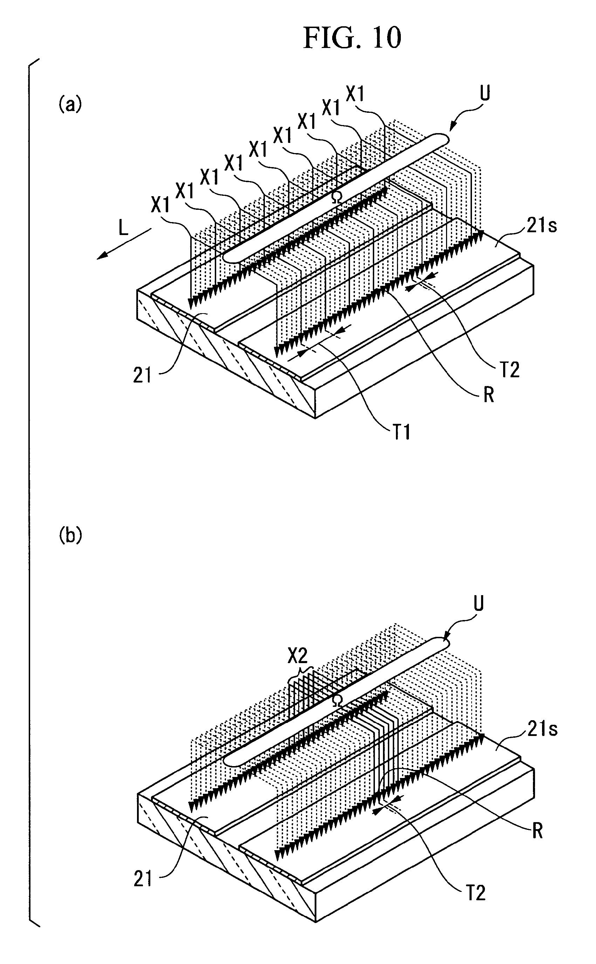

In contrast, in the above-described defect portion determining step (P4), as shown in FIG. 10 (a), a probe unit U in which a plurality of probes are formed along the longitudinal direction L of the compartment element 21s by the measurement interval T2 may be used.

Firstly, a bias electrical current (voltage) is intermittently applied to only a probe X1 for each predetermined wide measurement interval T1, and a rough position of the structural defect R is thereby determined.

Subsequently, as shown in FIG. 10 (b), a bias electrical current (voltage) is applied to a probe X2 disposed in a zone that is identified as having a structural defect R, that is, a zone in which the resistance is lowest in the probes to which a bias electrical current (voltage) is applied.

Here, since the measurement is performed by the measurement interval T2 that is an interval between the formed probes and that is narrower than the initial-wide measurement interval T1, the position of the structural defect R is further accurately determined in the compartment element.

As mentioned above, by use of the probe unit U in which the probes are thickly arrayed along the longitudinal direction L of the compartment element 21s by the measurement interval T2 and by appropriately changing the probe that applies the bias electrical current (voltage), it is possible to quickly detect the position of the structural defect R by only selecting the probe supplying the bias electrical current without the probe being moved in the longitudinal direction L.

In addition, as another detection method, a method for changing the interval between measurement terminals during measuring may be adopted.

In the case of using, for example, an apparatus shown in FIGS. 10 (a) and (b), initially, the interval between the terminals is set relatively large and the resistances are measured; if a resistance that is lower than a threshold value is detected or if the resistance became lower than a predetermined percentage thereof, the interval between the terminals is set to be narrow, and the resistances are measured for each of the terminals.

In the measuring for each of the terminals, if the resistance is higher than the threshold value or back to the normal value, the interval is back to the original interval, and the measurement is performed.

In addition, as another detection method, a method of determining a plurality of threshold values and of changing the interval between the terminals for each of the threshold values may be adopted.

The threshold values, for example, A, B, and C (A>B>C) of resistance are determined in advance.

If the resistance is greater than or equal to the threshold value A, the measurement is performed while using terminals and spacing ten terminals; if the resistance is less than or equal to threshold value A, the measurement is performed while using terminals and spacing five terminals; if the resistance is less than or equal to threshold value B, the measurement is performed while using terminals and spacing two terminals; and if the resistance is less than or equal to threshold value C, the measurement is performed while using each terminal.

If the resistance is high, conversely, by increasing the measurement interval each time the resistance exceeds the threshold value, the measurement is performed.

If the defects exist, the resistances gradually vary (refer to FIG. 8); therefore, by changing the measurement interval every threshold value as described above, it is possible to quickly and accurately detect the positions of the defects.

In addition, in the foregoing detection method, the case of using the apparatus is described, in which a plurality of terminals is arrayed as shown in FIG. 10, and the interval between the terminals used for measuring is changed.

In the case of measuring while moving the terminals, a method of changing the measurement interval or the moving speed thereof for each threshold value is realizable.

By use of the method for measuring the resistance between the foregoing adjacent compartment elements, the range in which the structural defect R exists can be restricted in the longitudinal direction L of the compartment element 21s; however, it is difficult to determine the position in which the structural defect R exists in the width direction W of the compartment element 21 s.

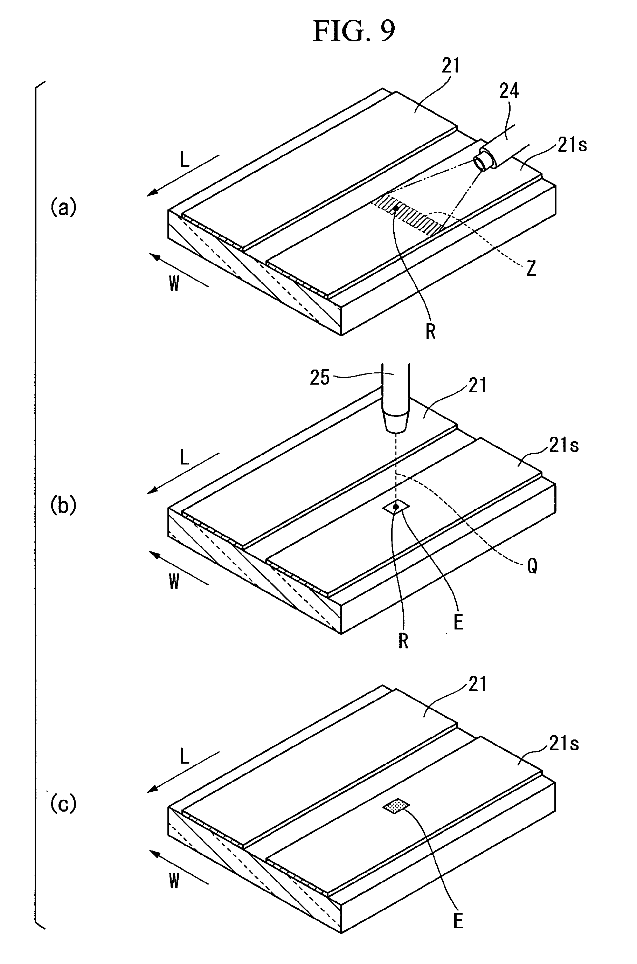

Consequently, the region Z in which the structural defect R exists and which is narrowed down by measuring of the resistance so as to be a narrow region in the compartment element is captured as an image by an image capturing section (refer to FIG. 9(a)).

As the image capturing section, for example, a device in which CCD camera 24 is combined with a lens having a high magnification ratio is employed.

By means of this structure, the position in which the structural defect R exists in the width direction W of the compartment element 21s in the region Z is accurately determined based on the image of the region Z in which the structural defect R exists and which is captured as an image by the CCD camera 24.

In other cases, as a method for determining the positions of the structural defect R from the image captured in the above-described manner, methods are adopted in which a visual determination by a human is performed or a determination by use of a computer is performed so as to compare the image data of the compartment element of an object to be inspected and the image data of the non-defect compartment element which is captured as an image in advance.

After the resistance distribution between the compartment elements adjacent to each other is measured and the region Z in which the structural defect R exists is determined in the longitudinal direction L of the compartment element 21 s in the above-described manner, the narrowed region Z is further captured as an image by the image capturing section (CCD camera 24).

Because of this, it is possible to accurately determine the pinpoint position in which the structural defect R exists in the compartment element 21 s.

In the case of image-capturing an object to be inspected and having a large area using a conventional defect determining method, time-consuming operation is necessary.

In contrast, the defect determining method in the embodiment is restricted and only used for image-capturing the region having a small area Z which is narrowed down in advance based on the resistance distribution that can be measured in a short amount of time.

For this reason, it is possible to promptly and accurately determine the position of the structural defect R in an extremely short amount of time.

After the positions of the pinpoint structural defect R are accurately determined in the compartment element 21 s, subsequently, the structural defect R of the photovoltaic cell is repaired (repairing step: P5).

In the repairing step, the pinpoint structural defect R that is determined by measuring resistances and by image-capturing an image is irradiated with a laser beam Q from a laser apparatus 25 at a minimized scope (refer to FIG. 9(b)).

Consequently, a semiconductor layer or an electrode of the portion in which the structural defect R exists is only evaporated and removed (refer to FIGS. 9(c) and 4(b)).

In the above-described manner, due to irradiating the determined pinpoint structural defect R with the laser beam Q in a minimized scope, it is possible to only remove the region E3 from the minimized region E1 including the structural defect R.

It is possible to minimize degradation of photoelectric conversion characteristics, which are caused by repairing, and it is possible to remove the structural defect R so that a repaired mark is hardly visible in appearance.

That is, each of the structural defects A1 to A3 shown in FIG. 4(a) is removed as presented by reference numerals E1 to E3 of FIG. 4(b).

In the above-description, after the defect compartment determining step (P3), the defect portion determining step (P4), and repairing step (P5), the structural defect which exists in the compartment element of the photovoltaic cell is determined and removed.

The photovoltaic cell in which the structural defect is removed is transmitted to the protective layer formation step (P6); and the photovoltaic cell is processed in post-steps.

According to the foregoing photovoltaic cell manufacturing method of the invention, firstly, a photovoltaic cell including a compartment element having a structural defect is sorted out in the defect compartment determining step.

Consequently, the sorted photovoltaic cell having a structural defect is only transferred to the defect portion determining step.

In the defect portion determining step, the portion having the structural defect is determined with precision by measuring the resistances and by image-capturing the narrowed region.

Because of this, it is possible to effectively manufacture a photovoltaic cell without a structural defect.

In a photovoltaic cell manufacturing apparatus of the invention, it is only necessary to include a resistance measuring section and an image capturing section (CCD camera 24). The resistance measuring section measures resistances of a plurality of portions between the compartment elements 21 in order to narrow down the positions of the structural defect R in the defect portion determining step shown in FIGS. 7(a), (b) and FIGS. 9(a) to (c). The image capturing section image-captures the region Z in which the structural defect R exists, and the structural defect R is which is narrowed by use of the resistance measuring section.

It is only necessary for the resistance measuring section to be constituted of two-probe or four-probe resistance measuring apparatus, and a transfer apparatus allowing the probes to relatively move with respect to the compartment element 21 along the length direction L.

In addition, as an image capturing section, for example, an optical formula camera, a CCD camera, or the like is adopted.

Consequently, in the repairing step shown in FIGS. 9(a) to (c), the positions of the structural defect R are accurately determined by the image capturing section.

Additionally, as the repairing section irradiating the accurately determined structural defect R with the laser beam Q, for example, the laser apparatus 25 is employed.

In the foregoing repairing section, it is only necessary to further include a scanning mechanism which scans a predetermined range with a laser beam or includes a transfer table, on which a photovoltaic cell that is an object to be repaired is mounted and which horizontally transfers the photovoltaic cell.

### Industrial Applicability

As described above in detail, the present invention is applicable to a method and an apparatus for manufacturing a photovoltaic cell, where a damage to a photoelectric converter of a photovoltaic cell is suppressed, portions in which a structural defect is generated are accurately determined, and the determined structural defects can be reliably removed and repaired.

## Claims

1. A photovoltaic cell manufacturing method comprising:
forming a photoelectric converter including a plurality of compartment elements, the compartment elements adjacent to each other being electrically connected;
determining the compartment element having a structural defect in the photoelectric converter;
narrowing down a region in which the structural defect exists in the compartment element based on a resistance distribution which is obtained by measuring resistances of a plurality of portions between the compartment elements adjacent to each other, image-capturing the inside of the narrowed region in which the structural defect exists by use of an image capturing section, accurately determining a position of the structural defect from the obtained image so that a portion in which the structural defect exists in the compartment element is restricted; and
removing the structural defect by irradiating the portion in which the structural defect exists with a laser beam.

2. The photovoltaic cell manufacturing method according to claim 1, wherein
when the portion in which the structural defect exists is restricted, a degree of density for measuring is changed at least two times or more and the resistances are measured.

3. The photovoltaic cell manufacturing method according to claim 1 or claim 2, wherein
when the portion in which the structural defect exists is restricted, a resistance measuring apparatus having four probes is used to measure the resistances.

4. A photovoltaic cell manufacturing apparatus manufacturing a photovoltaic cell including a photoelectric converter having a plurality of compartment elements, the apparatus comprising:
a resistance measuring section that measures resistances of a plurality of portions between the compartment elements adjacent to each other in order to narrow down a region in which a structural defect exists in the compartment element having the structural defect in the photoelectric converter;
an image capturing section that image-captures the inside of the narrowed region in which the structural defect exists and accurately determines a position of the structural defect; and
a repairing section that removes the structural defect by irradiating the structural defect with a laser beam.
